# EUROPEAN PATENT APPLICATION

(11) **EP 1 967 604 A1**
(43) Date of publication of application: **10.09.2008**
(21) Application number: 07004792.3
(22) Date of filing: 08.03.2007
(51) Int. Cl.: C23C 14/24, C23C 14/56, C23C 16/06, C23C 16/54

(54) **Evaporation crucible and evaporation apparatus with directional evaporation**

(71) Applicant: Applied Materials, Inc., Santa Clara, CA 95054 (US)
(72) Inventor: Klug, Thomas, 63762 Grossostheim (DE); König, Michael, 60529 Frankfurt am Main (DE); Englert, Ulrich, 63869 Heigenbrücken (DE); Bender, Marcus, 63456 Hanau (DE); Keller, Stefan, 63814 Mainaschaff (DE); Lopp, Andreas, 63579 Freigericht (DE); Buschbeck, Wolfgang, 63454 Hanau (DE)
(74) Representative: Zimmermann, Gerd Heinrich

(57) **Abstract**

An evaporation crucible is described. The evaporation crucible includes: an electrically conductive body (120; 420) and a cover (150; 450; 750; 850); the body having a first electrical connection (162) and a second electrical connection (164) for applying a heating current through the body, the body includes: a first chamber (130) providing a material feeding area and a melting area, the first chamber including a first chamber bottom and a first chamber wall, a second chamber (140) providing an evaporation area, the second chamber including a second chamber bottom and a second chamber wall, and a transport region (145) connecting the first chamber and the second chamber adapted for a flow of a material to be evaporated, wherein the body has a shape to provide a temperature gradient from the first chamber to the second chamber by increasing the current density in the second chamber; wherein the cover forms an evaporation enclosure with the second chamber; and wherein the evaporation enclosure has a distributor orifice providing a vapor outlet.

## Description

### FIELD OF THE INVENTION

The invention generally relates to thin-film forming apparatuses and crucibles used in an evaporation apparatus for thin film forming. Particularly, it relates to the crucible for evaporation of alloys or metals. Specifically it relates to an evaporation crucible and to an evaporation apparatus.

### BACKGROUND OF THE INVENTION

For thin-film coating of a material on a substrate, an evaporator can be used. For example, coatings with metal films, which e.g. provide a capacitor of a large panel display or a protective layer on a flexible substrate or web, can be applied with evaporators. Specifically, for large panel displays, a substrate, which can be provided as a large and relatively thin glass plate, might be vertically positioned in a coating process and coated with a vertical evaporator.

Particularly for vertical evaporation, a source for a material vapor to be deposited on a substrate is commonly provided with a vertical nozzle pipe, which defines a linear vertically extending source for coating a vertically aligned substrate.

The linear sources provided thereby, have a high complexity and are expensive to manufacture and to maintain. Additionally, the vertically extending nozzle pipe provides a substantial thermal irradiation towards the substrate.

### SUMMARY OF THE INVENTION

In light of the above, the present invention provides an evaporation crucible according to independent claims 1 and 23, and an evaporation apparatus according to claims 24 and 26.

According to one embodiment, an evaporation crucible is provided. The evaporation crucible includes: an electrically conductive body and a cover; the body having a first electrical connection and a second electrical connection for applying a heating current through the body, the body includes: a first chamber providing a material feeding area and a melting area, the first chamber including a first chamber bottom and a first chamber wall, a second chamber providing an evaporation area, the second chamber including a second chamber bottom and a second chamber wall, and a transport region connecting the first chamber and the second chamber adapted for a flow of a material to be evaporated, wherein the body has a shape to provide a temperature gradient from the first chamber to the second chamber by increasing the current density in the second chamber; wherein the cover forms an evaporation enclosure with the second chamber; and wherein the evaporation enclosure has a distributor orifice providing a vapor outlet.

According to a further embodiment, an evaporation crucible is provided. The evaporation crucible includes: a heatable body and a cover; the body includes: a first chamber providing a material feeding area and a melting area, the first chamber including a first chamber bottom and a first chamber wall; a second chamber providing an evaporation area, the second chamber including a second chamber bottom and a second chamber wall; and a transport region connecting the first chamber and the second chamber adapted for a flow of a material to be evaporated; wherein the cover forms an evaporation enclosure with the second chamber; wherein the body is heatable to provide an increasing temperature gradient from the first chamber to the second chamber; and wherein the evaporation enclosure has a distributor orifice providing a vapor outlet.

According to yet a further embodiment, an evaporation apparatus is provided with at least one evaporation crucible. The evaporation crucible includes: a heatable body and a cover; the body includes: a first chamber providing a material feeding area and a melting area, the first chamber including a first chamber bottom and a first chamber wall; a second chamber providing an evaporation area, the second chamber including a second chamber bottom and a second chamber wall; and a transport region connecting the first chamber and the second chamber adapted for a flow of a material to be evaporated; wherein the cover forms an evaporation enclosure with the second chamber; wherein the body is heatable to provide an increasing temperature gradient from the first chamber to the second chamber; and wherein the evaporation enclosure has a distributor orifice providing a vapor outlet. The evaporation apparatus includes further: a heating unit adapted for heating the melting area and the evaporation area to different temperatures.

According to another embodiment, an evaporation apparatus is provided with at least one evaporation crucible. The evaporation crucible includes: an electrically conductive body and a cover; the body having a first electrical connection and a second electrical connection for applying a heating current through the body, the body includes: a first chamber providing a material feeding area and a melting area, the first chamber including a first chamber bottom and a first chamber wall, a second chamber providing an evaporation area, the second chamber including a second chamber bottom and a second chamber wall, and a transport region connecting the first chamber and the second chamber adapted for a flow of a material to be evaporated, wherein the body has a shape to provide a temperature gradient from the first chamber to the second chamber by increasing the current density in the second chamber; wherein the cover forms an evaporation enclosure with the second chamber; and wherein the evaporation enclosure has a distributor orifice providing a vapor outlet.

Further advantages, features, aspects and details that can be combined with the above embodiments are evident from the dependent claims, the description and the drawings.

Embodiments are also directed to apparatuses for carrying out the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Fig. 1a shows a schematic side view of an evaporation crucible for vapor evaporation of a material film to be deposited on a substrate, the crucible according to the embodiments described herein includes a first chamber, a second chamber and a cover;

Fig. 1b shows a schematic top view further illustrating embodiments described with respect to Fig. 1a;

Fig. 2a shows a schematic side view of a further evaporation crucible with a first chamber, a second chamber, a cover and a distributor orifice according to the embodiments described herein;

Fig. 2b shows a schematic top view illustrating embodiments described with respect to Fig. 2a;

Fig. 3 shows another embodiment of an evaporation crucible according to the embodiments described herein;

Fig. 4 shows a schematic side view of an even further evaporation crucible with a first chamber, a second chamber, a cover and an orifice according to embodiments described herein;

Fig. 5 shows a schematic side view of components of a vertical evaporator unit according to embodiments described herein;

Fig. 6 shows an aperture, which might be used with embodiments described with respect to Fig. 5 for thin film coating of a substrate;

Fig. 7 shows a schematic side view of an evaporation crucible having a first and second chamber and a cover according to embodiments described herein;

Fig. 8 shows a schematic side view o components of a vertical evaporation apparatus with embodiments of evaporation crucibles described with regard to Fig. 7;

Fig. 9 shows a schematic view of an aperture that can, according to embodiments described herein, be used in an application of, e.g., Fig. 8;

Fig. 10 shows a schematic side view of an evaporation crucible having a first chamber, second chamber, a cover and an orifice according to embodiments described herein,

Fig. 11 shows an arrangement for vertical evaporation including point sources according to embodiments described herein; and

Fig. 12 shows a schematic view of components of an evaporation apparatus for horizontal evaporation including point sources according to embodiments described herein.

### DETAILED DESCRIPTION OF THE DRAWINGS

Without limiting the scope of the present application, in the following aluminum is described as a material to be deposited on a substrate. The invention is still directed to metals, alloys or other materials to be evaporated and used for coating of a substrate. Further, without limiting the scope of the present invention, a substrate is typically referred to as a glass substrate as often used for display technology, e.g., displays. Embodiments of the present invention can be applied to thin-film vapor deposition on other substrates and for other technologies, e.g., for flexible substrates or webs.

Within the following description of the drawings, the same reference numbers refer to the same components. Generally, only the differences with respect to the individual embodiments are described.

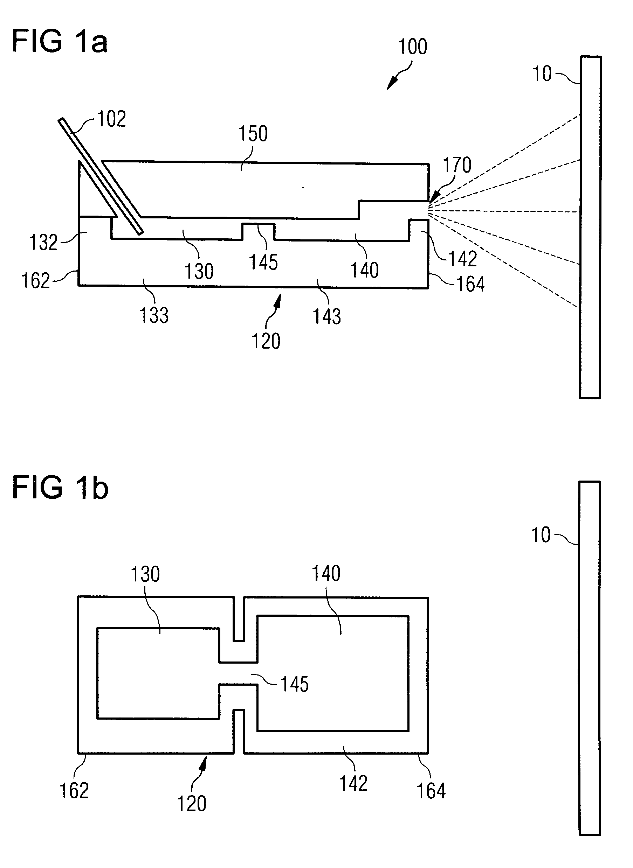

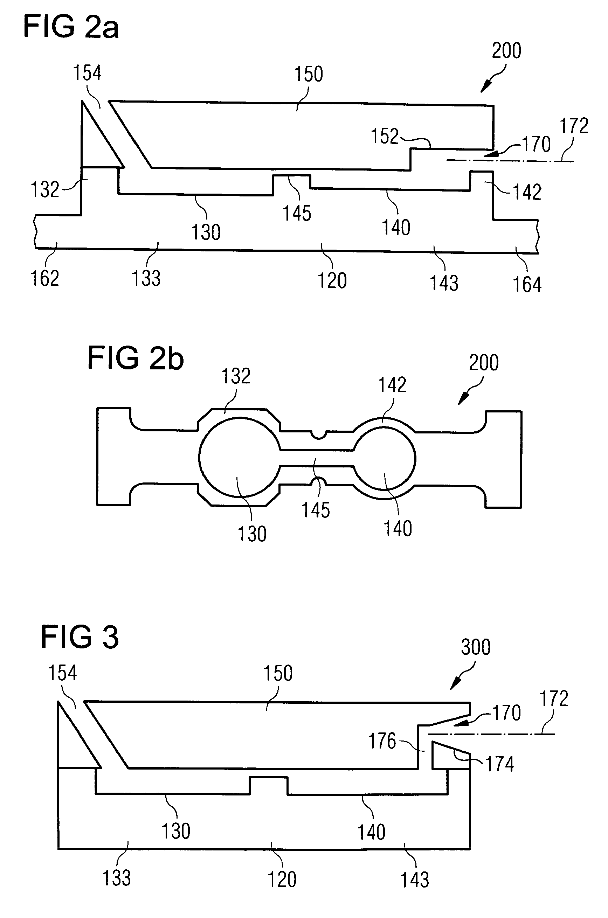

Figs. 1a and 1b show a schematic side view and top view, respectively, of an evaporation crucible 100. The crucible 100 enables thin film forming of a material on a substrate 10. According to typical embodiments described herein, the material to be vapor deposited on the substrate 10 can be a metal like gold, copper, aluminum, or alloys including at least one of these metals. According to different embodiments, the side view shown in Fig. 1a can also refer to a top view as shown in Fig. 2a or another shape of a body when seen from above.

Vapor deposition of thin films may, for example, be applied for organic light emitted diodes (OLED), for other TFT or display device, or generally for thin-film coating on glass substrates or foils. As an example, thin metal films are provided for display applications in order to control individual pixels of a display.

The evaporation crucible 100 includes a body 120 and a cover 150. If the material, for example aluminum, is provided by continuously feeding the material to be deposited with a feeding wire 102, an equilibrium can be maintained such that the amount of material in the system is substantially constant. Thereby, the amount of material inserted in the system is provided by the diameter and the feeding speed of the feeding wire 102. In order to provide an equilibrium, the amount of material, which is evaporated from the evaporation crucible 100, and the amount of material fed in the system should be similar.

Fig. 1a and Fig. 1b illustrate a first chamber 130 and a second chamber 140. Between the first chamber and the second chamber a transport region 145 is provided. The first chamber 130 provides a melting area for melting the material, which is fed into the system, e.g., by feeding wire 102. The second chamber 140 provides an evaporation area for evaporating the material provided from the melting area via the transport region.

The first chamber 130 provides a chamber with a chamber bottom 133 and a chamber wall 132. The second chamber 140 provides chamber with a chamber bottom 143 and a chamber wall 142. Additionally, a first electrical connection 162 and a second electrical connection 164 are provided.

According to one embodiment, the feed wire 102 may be provided from a roll. Thereby, the material can be provided continuously by the wire 102 of the material to be melted in the melting area of the first chamber 130. According to a further embodiment, the wire can include a single element. In the case an alloy is to be deposited on the substrate 10, the wire can be provided with the material being an alloy. According to an even further embodiment, if an alloy is to be deposited on the substrate 10, several wires of the materials constituting the desired alloy can be provided to form the desired alloy. Thereby, the feeding speed of the wires can be adjusted to provide the desired alloy composition.

The material to be deposited is melted and evaporated by heating the evaporation crucible 100. Heating can be conducted by providing a power source (not shown) connected to the first electrical connection 162 and the second electrical connection 164. Thereby, heating is conducted by the current flowing through the body 120 of the crucible 100. According to other embodiments, heating may also be conducted by an irradiation heater of an evaporation apparatus or an inductive heating unit of an evaporation apparatus. Thereby, temperature gradients, which are described below with regard to a heating current, can correspondingly be provided.

As shown in Fig. 1b, the wall 132 of the first chamber 130 has a larger material thickness than the wall 146 of the transport region 145. Further, the wall 146 of the transport region 145 has a larger material thickness than the wall 142 of the second chamber 140. Thus, the cross-section provided for the current flow is higher in the region of the first chamber as compared to the transport region or the region of the second chamber.

Within the regions having a smaller cross-sectional area, the resistance of the body is increased. Thereby, the heating power provided can be calculated according to equation P=R I², wherein P is the power, R is the resistance and I is the current. As a result of the proportion between the resistance and the cross-sectional area, the temperature is increased in regions having a smaller cross-sectional area. Thus, it is possible to control the resistance of the different areas of the crucible such that desired temperatures are provided in the different areas. For example, the temperature in the melting area can be about 1000°C to 1200°C, the temperature in the transport region can be 1260°C to 1500°C, and the temperature in the evaporation area can be in the range of 1300°C to 1600°C, e.g., about 1560°C.

For example, the temperature in the melting area of the first chamber 130 is about 300 to 500°C above the melting temperature of the material to be deposited and the temperature in the evaporation area is about 900°C above the melting temperature of the material to be deposited. The temperatures in the first chamber and the transport region are chosen such that there is no significant evaporation in the first chamber and the transport region. Generally, it may be possible to choose a temperature in the melting area of the first chamber which is slightly above the melting temperature. However, the wire provided for feeding the material results in a decrease of the temperature in the melting area. Therefore, the temperature in the melting area is chosen to be sufficiently above the melting temperature.

Typically, an upper limit of the temperature can be given by the temperature stability of the evaporation crucible.

According to one embodiment, the cross-sectional area for the current flowing from the first electrical connection 162 to the second electrical connection 164 can be controlled by the chamber wall thicknesses 132, 146 and 142 of the respective regions. Thereby, optionally, it is also possible to provide a gradient of the cross-sectional area and, thus, a temperature gradient, within one area. That is, the temperature can be varied by providing a desired cross-sectional area across the region of the first chamber, the transport region and/or the region of the second chamber.

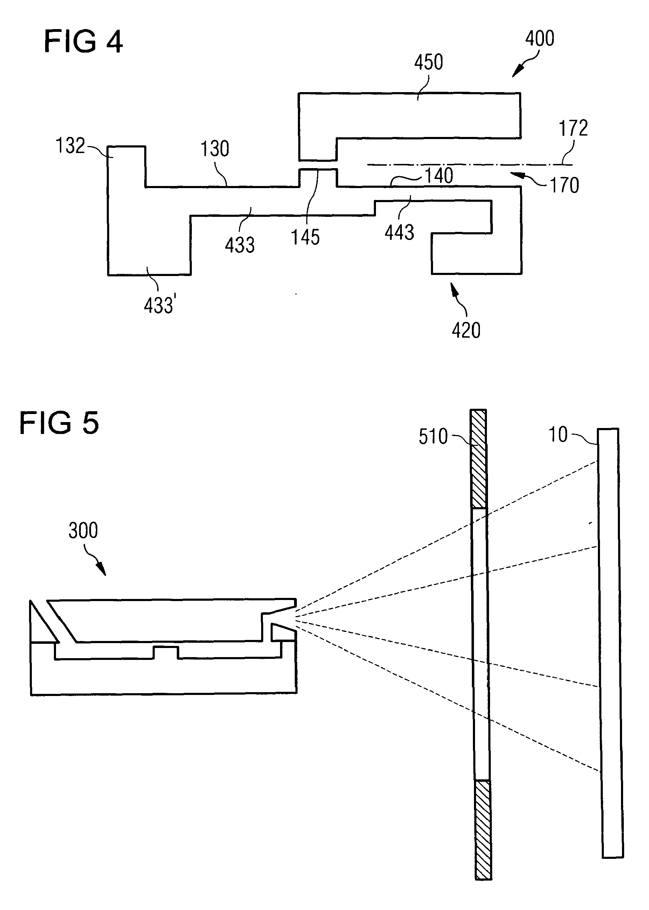

According to another embodiment, the cross-sectional area between and/or within different regions can also be varied by varying the thickness of the material of the body at the bottom. Thereby, as for example shown with respect to Fig. 4, the chamber bottom 433 in the first chamber 130 can have a larger material thickness than the chamber bottom 443 in the second chamber. According to even further embodiments, the cross-sectional area and, thereby, the heating resistance in different areas of the evaporation crucible can also be adapted by adjusting the wall thicknesses and the bottom thicknesses.

According to even further embodiments, the resistance of different areas of the evaporator crucible 100 can further be controlled by changing the material composition of the evaporator crucible body 120.

Generally, according to embodiments described herein, the materials of the crucible should be conductive, the materials should be temperature resistant to the temperatures used for melting and evaporating, and the materials should be resistant with regard to the liquid materials or the material vapor, respectively. For example, liquid aluminum is highly reactive and can provide significant damage to crucibles for melting aluminum. According thereto, typically, materials selected from the group consisting of a metallic boride, a metallic nitride, a metallic carbide, a non-metallic boride, a non-metallic nitride, a non-metallic carbide, nitrides, borides, graphite, TiB2, BN, B₄C, SiC and combinations thereof can be used.

The difference in electrical resistivity of these materials can be used to further adapt the heat generation in the crucible. Thereby, the material composition in the melting area of the first chamber 130 can be chosen to have a lower resistivity than the material composition of the evaporation area of the second chamber.

Fig. 1a shows a cover 150. The cover 150 forms an enclosure with the bottom and the wall of the second chamber 140 and an enclosure with the bottom and the wall of the first chamber. According to another embodiment a cover portion can also cover at least a portion of the first chamber. According to a further embodiment the cover 150 can provide the cover portion covering at least a portion of the first chamber. According to an even further embodiment, no enclosure with the first chamber can be formed by the cover 150 or another cover. A distributor orifice 170 is provided between the cover 150 and a portion of the wall 142. Within the embodiments described with respect to Figs. 1a and 1b, the distributor orifice 170 has a substantially horizontal evaporation axis. Thus, the evaporator crucible 100 can typically be used for vertical evaporation, wherein the substrate 10 is vertically arranged. According to typical embodiments for vertical evaporator units including crucibles, the substrate 10 travels horizontally past the evaporator crucible 100 and, thereby, provides a continuous coating process of the vertically arranged substrate in the horizontal direction.

By forming an enclosure with a distributor orifice around the evaporation area, a point source for material vapor can be provided. Thereby, a redirecting of the vapor, for example in a vertical nozzle pipe, that is a vertical linear evaporation tube, can be avoided. Thus, a vertical evaporation can be simplified and costs for manufacturing and maintaining a vertical evaporator can be decreased.

According to the embodiments described with respect to Figs. 1a and 1b, the material, for example aluminum, is provided by the wire 102. The aluminum is melted in the melting area of the first chamber 130 and reaches the evaporation area of the second chamber 140 via a transport region 145. In light of the higher temperature of the evaporation area as compared to the melting area, the liquid aluminum in the evaporation area is evaporated and provided through the distributor orifice with an evaporation axis towards the substrate 10.

Thereby, it should be considered that the liquid aluminum is typically not provided with a thickness of more than several hundreds micrometers. It can, according to some embodiments, even be provided with a film thickness in the first and second chambers of less than 100 µm. Accordingly, the flow of the liquid aluminum is not based on gravity or the like, but rather on temperature gradients, capillary forces, or the like. Further, a part of the material vapor that might be directed backwards towards the first chamber is condensed at lower temperature regions adjacent to the first chamber. Evaporation towards the material wire 102 can, thus, be reduced or prevented.

According to one embodiment, the cover 150 can be made of the non-conductive material. Thereby, it may include BN, or the like. A nonconductive cover is only passively heated by the adjacent portion of the body. According to another embodiment, the cover 150 can be made of a conductive material. A conductive material can include graphite or TiB₂. According to further embodiments AlN and/or BN can be added. Thereby, the cover can carry a current flow of currents applied by the first electrical connection and the second electrical connection. According to such embodiments, the cover 150 is also actively heated. In this case, according to an even further embodiment, the cover can also be provided with varying cross-sectional areas for control of the temperature of the cover 150. It is optionally possible to apply a separate heating current for the cover.

According to a further embodiment, the first chamber can have a length, that is, a dimension from the wall 132 adjacent to the first connection to the transport region of 20 mm to 90 mm, typically, for example, 30 mm to 70 mm. The transport region may, according to even further embodiments, have a length, that is, a dimension from the first chamber to the second chamber of about 3 mm to 55 mm, typically, for example, 4 mm to 50 mm. The volume of the second chamber can, according to yet further embodiments, be similar to the area of the first chamber or slightly, e.g., up to 20% smaller. According to further, embodiments, the volume of the first chamber can by smaller than the volume of the second chamber, e.g., up to about 0.6 times the volume of the second chamber.

As shown in Fig. 1a, the evaporation crucible 100 is positioned in front of a vertically arranged substrate 10. Depending on the distance of the evaporator crucible from the substrate, the size of the evaporation area on the substrate can be controlled. In light of the fact that embodiments described herein allow for omittance of a vertical nozzle pipe for redirecting the material vapor at the plurality of positions, the distance from the evaporator crucible 100 to the substrate 10 may be increased, such that an enlarged surface of the substrate is coated with the material. Thereby, for example, a distance of 100 to 600 mm can be realized.

According to different embodiments, which might be combined with other embodiments herein, a distributor orifice 170 is provided with a channel length of 2 to 15 mm. According to even further embodiments, the cross-sectional area of the orifice is in the range of 40 mm² to 175 mm², typically, for example, in the range of 50 mm² to 150 mm².

According to different embodiments that might be combined with any of the embodiments described herein, the electrical connections may be provided at the body such that the body is contacted with contact elements of an evaporation apparatus, e.g. cooled contact elements, on a side portion of the body next to the first chamber and the second chamber, respectively. Alternatively, the contact elements can be formed by protrusions of the main body. Thereby, the protrusions can be formed to be contacted by contact elements of the evaporation apparatus. Generally, the electrical contacts are provided for applying a heating current through the body. The current is thereby applied by a power source of the evaporation apparatus.

Further embodiments will now be described with respect to Figs. 2a and 2b. Fig. 2a is a schematic side view of an evaporation crucible 200. Fig. 2b is a schematic top view of the body 120 of the evaporation crucible 200. According to different embodiments, the side view shown in Fig. 2a can also refer to a top view as shown in Fig. 1a or another shape of the body when seen from above.

Within Fig. 2a the body 120 is provided. Electrical connections 162 and 164 are partly shown. As described above, the body provides the first chamber 130 with the chamber bottom 133 and the chamber walls 132, a transport region 145, and a second chamber 140 with the chamber bottom 143 and chamber walls 142. According to the embodiments described with respect to Figs. 2a and 2b, the cover 150 provides an enclosure for the first chamber 130 and an enclosure for a second chamber 140. Within cover 150, an opening 154 for introducing the material wire (not shown) is provided. Further, a recess 152 is provided in the cover 150. The recess 152 and the chamber wall 142 of the second chamber 140 provide a distributor orifice 170 with a substantially horizontal evaporation axis 172.

Further embodiments described herein are provided by modifying the embodiments described with respect to Figs. 1a and 1b. For example, the recess 152 in the cover 150 as shown in Fig. 2a may be provided, may not be provided or may be differently shaped.

As shown in Fig. 2b, the first chamber 130 and the second chamber 140 are, according to embodiments herein, provided in a rectangular shape. According to even further embodiments, the corners or edges, respectively, of the first chamber 130, the second chamber 140 and the transport region 145 can be rounded in order to decrease the thermal stress introduced on heating of the evaporation crucible.

According to one embodiment, the cover 150 can be made of the non-conductive material. Thereby, it may include BN, or the like. A nonconductive cover is only passively heated by the adjacent portion of the body. According to another embodiment, the cover 150 can be made of a conductive material. A conductive material can include graphite or TiB₂. According to further embodiments AIN and/or BN can be added. Thereby, the cover can carry a current flow of currents applied by the first electrical connection and the second electrical connection. According to such embodiments, the cover 150 is also actively heated. In this case, according to an even further embodiment, the cover can also be provided with varying cross-sectional areas for control of the temperature of the cover 150. It is optionally possible to apply a separate heating current for the cover.

As shown in Fig. 2a, according to further embodiments, the chamber bottom 133 of the first chamber can be at a lower level than the chamber bottom 143 of a second chamber 140. According to yet further embodiments (not shown), the chamber bottom 143 of the second chamber may also be at a lower level. For the embodiments including chamber bottom portions at different height, the transport region can optionally have a racing or falling slope.

As shown in Fig. 3, further embodiments of evaporation crucibles can include a modified distributor orifice 170. The distributor orifice 170 of the evaporation crucible 300 shown in Fig. 3 can also be used for other embodiments described herein. In Fig. 3, the cover 150 includes the first orifice portion 176 and an outlet portion 174. The first orifice portion extends in vertical direction and connects the evaporation area of the second chamber 140 with the outlet portion 174 of the distributor orifice. The outlet portion 174 is funnel-shaped in order provide a wider material vapor distribution. The distributor orifice 170 shown in Fig. 3 has a substantially horizontal directional evaporation axes 172.

As already explained with respect to Figs. 1a and 1b, a crucible 300 can be provided according to a variety of embodiments. The crucible enables a thin film forming of a material on substrate 10. It includes a body 120 and a cover 150. A feeding wire (not shown) can be provided through the opening 154 in the cover 150 into the melting area of the first chamber 130.

Fig. 3 illustrates a first chamber 130 and a second chamber 140. Between the first chamber and the second chamber a transport region is provided. The first chamber 130 provides a melting area for melting the material and the second chamber 140 provides an evaporation area for evaporating the material provided from the melting area via the transport region.

The material to be deposited is melted and evaporated by heating the evaporation crucible 300. Heating can be conducted by providing a power source (not shown) connected to the first and second electrical connections (not shown). According to different embodiments, different temperatures across the body and, optionally, across the cover can be provided by varying the cross-sectional areas carrying a current and/or by varying the electrical resistivity of the crucible material in different areas. For example, the temperature in the melting area can be about 1000°C to 1200°C, the temperature in the transport region can be 1260°C to 1500°C, and the temperature in the evaporation area can be in the range of 1300°C to 1600°C, e.g., about 1560°C.

Generally, according to embodiments described herein, the materials of the crucible should be conductive, the materials should be temperature resistant to the temperatures used for melting and evaporating, and the materials should be resistant with regard to the liquid materials or the material vapor, respectively. For example, liquid aluminum is highly reactive and can provide significant damage to crucibles for melting aluminum. According to thereto, typically, materials selected from the group consisting of a metallic boride, a metallic nitride, a metallic carbide, a non-metallic boride, a non-metallic nitride, a non-metallic carbide, nitrides, borides, graphite, TiB₂, BN, and a combination thereof can be used.

Fig 3 shows the cover 150. The cover 150 forms an enclosure with the bottom and the wall of the second chamber 140. The distributor orifice 170 is provided within the cover 150. Within the embodiments described with respect to Fig. 3, the distributor orifice 170 has a substantially horizontal evaporation axis. Thus, the evaporator crucible 300 can typically be used as a point source for vertical evaporation, wherein the substrate 10 is vertically arranged. By forming an enclosure with a distributor orifice around the evaporation area, the redirecting of the vapor, for example, in a linear evaporation tube (vertical nozzle pipe) can be avoided. Thereby, a vertical evaporation can be simplified and costs for manufacturing and maintaining a vertical evaporator can be decreased.

According to different embodiments already explained with respect to Figs. 1a and 1b, the cover 150 can be made of the non-conductive material or a conductive material. Further embodiments of the evaporation crucible shown in Fig. 3 can be realized by the dimension of the first chamber, the second chamber and the transport region, which are described above. Yet further embodiments may be realized by the above described dimensions of the distributor orifice 170. According to even further, embodiments the funnel-shape opening angle (half-angle) can be in the range of 5° to 30°.

Fig. 4 shows an evaporation crucible 400. The body 420 includes a first chamber 130 and a second chamber 140. The chamber bottom portions are shaped to design a plurality of desired cross-sectional areas for providing different temperature regions. Accordingly, the chamber bottom has a first region 433' and a second region 433 in proximity to the first chamber 130. The first chamber 130 further includes a side wall 132, which is shown in Fig. 4. The second chamber 140 is adjacent to a chamber bottom region 433 and has the chamber bottom region 443. Thereby, the cross-section of the body 420 is decreased from the first chamber 130 towards the second chamber 140.

Within the sectional side view shown in Fig. 4, no sidewalls of the second chamber are shown. That is due to the position of the cross-section of the drawings with regard to the position of the orifice. However, the second chamber 140 has, outside the distributor orifice region, sidewalls 142.

The cover 450 covers the second chamber 140 and the transport region 145. Thereby, an enclosure is provided at the evaporation area of the second chamber 140.

Within Fig. 4, the distributor orifice 170 is provided with a substantially horizontal evaporation axis 174 and is formed by the ceiling portion of the cover 450 in the region of the second chamber and the bottom portion of the body 420 in the region of the second chamber.

Similarly, as described with respect to Figs. 1a to 3, further embodiments may be provided as a modification of the embodiment described with respect to Fig. 4.

Fig. 5 shows components of an evaporator apparatus. As an example, an evaporation crucible 300 is provided in front of a vertically arranged substrate 10. Between the evaporation crucible 300 and the substrate 10 an aperture unit 510 is positioned.

As an exemplary embodiment, a method of forming a thin film can be carried out by using an apparatus which is entirely placed in a vacuum atmosphere of 10⁻² to 10⁻⁶ mbar. Thereby, the thin film can be vapor deposited on a substrate or a carrier foil without contamination of particles from the ambient atmosphere.

As a further example, the embodiments described herein can be utilized for the coating of substrates for display technology or the like. Thereby, substrate size may be as follows. A typical glass substrate and, thereby, also a coating area can have dimensions of about 0.7 mm x 500 mm x 750 mm. Yet, next generation substrates can have a size of about 1500 mm x 1850 mm.

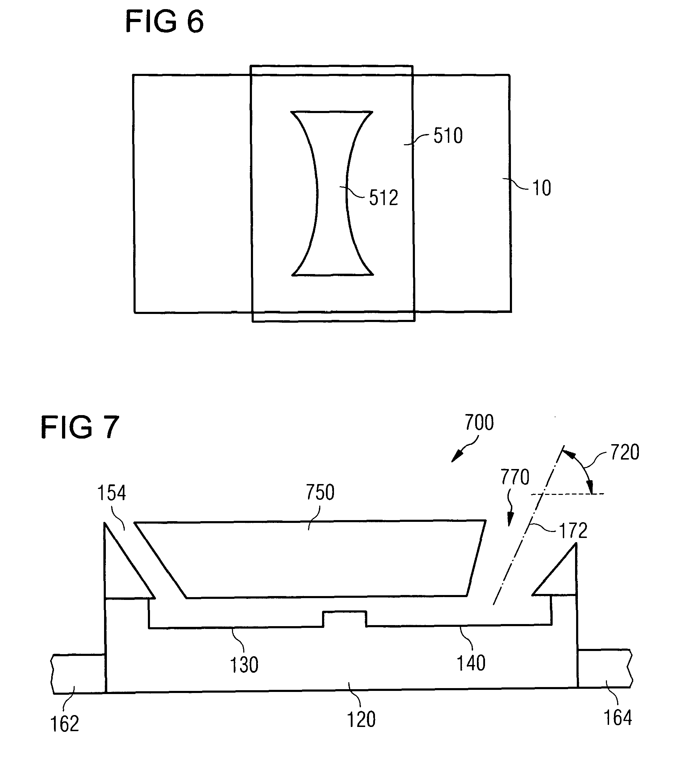

As described above, the typical distance between the evaporation crucible 300 and the substrate 10 can be in the range of 100 mm to 600 mm. As shown in Fig. 6, the aperture unit 510 has an aperture 512, which blocks material vapor that is directed towards the substrate and that is not in the region of the aperture opening 512 of the aperture unit 510. The distributor orifice of the evaporation crucible shown in Fig. 5 has, in the vertical direction, a vapor distribution which is not homogeneous. Typically, the amount of vapor emitted along the substantially horizontal evaporation axis is larger than the amount of material vapor emitted at different angles. According to some embodiments described herein, the vapor distribution is a cos²ⁿ distribution, wherein n is an integer. In order to compensate for the vertical vapor distribution of the distributor orifice, the aperture 512 of the aperture unit 510 is shaped such that the amount of vapor reaching the substrate 10 is reduced in the direction of the evaporation axis. Thereby, the material vapor amount reaching the substrate can be substantially homogeneous. The shape of the aperture 512 of the aperture unit 510 can have a shape compensating the cos²ⁿ vapor distribution, wherein n is an integer.

As described above, for typical embodiments of the evaporation apparatus, the vertically arranged substrate is horizontally moved along the evaporation crucible. Thereby, the amount of material is integrated across the horizontal vapor distribution of the evaporation crucible. Accordingly, there is no necessity for compensating a horizontal distribution if the substrate 10 is horizontally moved with respect to the evaporation crucible 300.

Fig. 7 shows an evaporation crucible 700. The body 120 provides the first chamber 130 including a melting area and a second chamber 140 including an evaporation area. First and second electrical connections 162 and 164, respectively, are provided to heat the evaporation crucible 700. The cover 750 provides an enclosure for the first chamber and an enclosure for the second chamber. An opening 154 is provided in the cover 750 for the material wire (not shown). Further, a distributor orifice 770 is provided in the cover 750. The distributor orifice 770 has an evaporation axis 172, which is inclined by the angle 720 as compared to the horizontal axis. According to typical embodiments, the angle of the directional evaporation hexes can be in the range of 10° to 60°. Depending on the application, the angle also be in the range of 0° to 45°.

As already explained with respect to Figs. 1a to 4, a crucible 700 can be provided according to a variety of embodiments. The crucible enables a thin film forming of a material on substrate 10. It includes a body 120 and a cover 750. A feeding wire (not shown) can be provided through the opening 154 in the cover 750 into the melting area of the first chamber 130.

Fig. 7 further illustrates a first chamber 130 and a second chamber 140. Between the first chamber and the second chamber at transport region is provided. The first chamber 130 provides a melting area for melting the material and the second chamber 140 provides an evaporation area for evaporating the material provided from the melting area via the transport region.

The material to be deposited is melted and evaporated by heating the evaporation crucible 700. Heating can be conducted by providing a power source (not shown) connected to the first and second electrical connections 162 and 164, respectively. According to different embodiments, different temperatures across the body and, optionally, across the cover can be provided by varying the cross-sectional areas carrying a current and/or by varying the electrical resistivity of the crucible material in different areas.

According to yet further embodiments already mentioned with respect to Figs. 1a and 1b, the cover 750 can be made of the non-conductive material or a conductive material. Further embodiments of the evaporation crucible shown in Fig. 7 can be realized by the dimension of the first chamber, the second chamber and the transport region, which are described above.

According to even further embodiments, which might be combined with other embodiments herein, the distributor orifice 770 is provided with a channel length of 2 mm to 15 mm along the evaporation axis 172. According to even further embodiments, the diameter of the orifice can be at least 2 mm, e.g., in the range of 4 to 34 mm. According to even further embodiments, the cross-sectional area of the orifice is in the range of 40 mm² to 175 mm², typically in the range of 50 mm² to 150 mm². According to even further, embodiments the funnel-shape opening angle (half-angle) can be in the range of 5° to 30°.

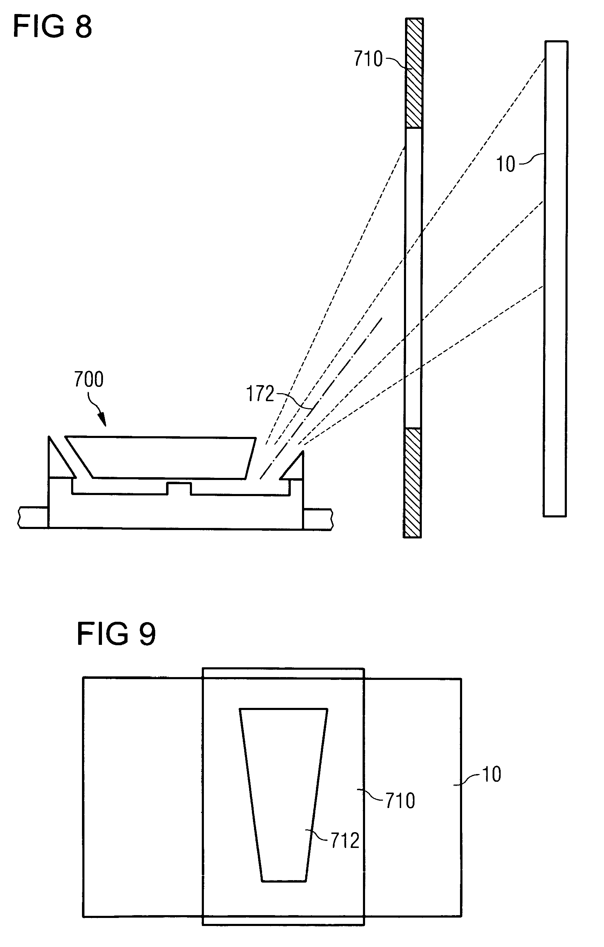

Fig. 8 shows components of an evaporator apparatus using an evaporation crucible 700 as described with respect to Fig. 7. For embodiments having an inclined directional distribution evaporation axis 172, the evaporation crucible can be positioned at the lower portion of a vertically arranged substrate 10. Thereby, the inclined evaporation axis provides material vapor to reach the upper portion of the substrate 10. According thereto, the distance between the evaporation crucible 700 and lower portion of the substrate 10 is smaller than the distance between the evaporation crucible and an upper portion of the substrate. Thus, the material flow density at the upper portion is lower than material flow density at the lower portion of the substrate. As shown in Fig. 9, an aperture unit 710 with an aperture 712 may be provided to compensate for the angle of the evaporation axis of the evaporation crucible 700. According to further embodiments, the shape of the aperture 712 of the aperture unit 710 may be combined with the shape of the aperture 512 of the aperture unit 510 shown in Fig. 6.

According to even further embodiments, the compensation of the evaporation distribution may also be conducted by a corresponding shape of the distributor orifice. According to yet even further embodiments, a compensation with an orifice shape and a compensation with an aperture unit can be combined.

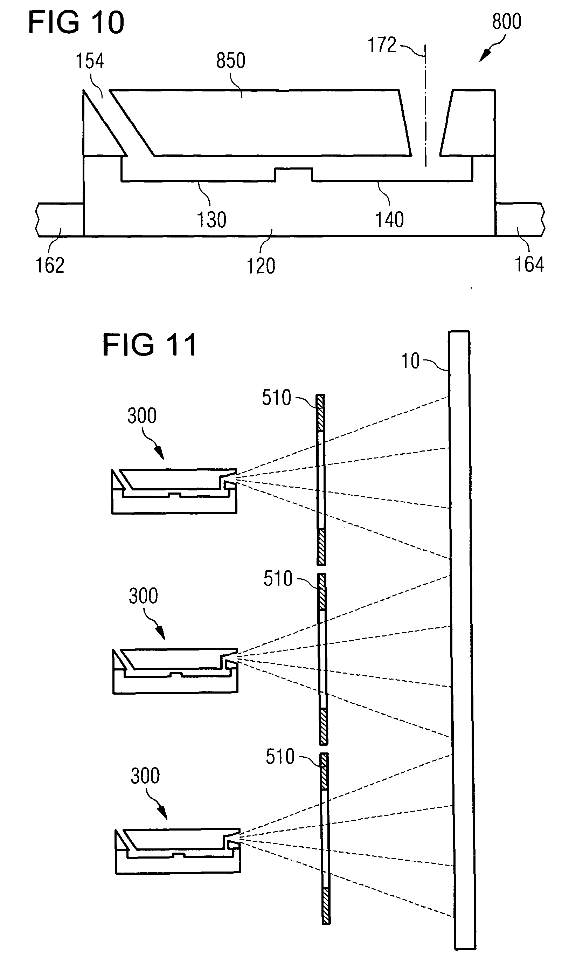

Fig. 10 shows a further evaporation crucible 800 according to embodiments described herein. The body 120, which is in communication with the first and second electrical connections 162 and 164, provides the first chamber 130 and a second chamber 140. The first chamber 130 includes a melting area for melting a material provided by the wire through opening 154. The second chamber 140 includes an evaporation area for evaporating material which flows from the first chamber 130 via a transport region to the second chamber. According to one embodiment, at least the second chamber is covered to form an enclosure. In Fig. 10, the cover 850 provides an enclosure around the melting area of the first chamber 130 and the evaporation area of the second chamber 140. A distributor orifice is formed in the area of the second chamber 140 within the cover 850. According to embodiments described with respect Fig. 10, the evaporation axis 172 is substantially vertical. Thereby, the horizontal evaporation point source can be provided.

As already explained with respect to Figs. 1a and 1b, a crucible 300 can be provided according to a variety of embodiments. The crucible enables a thin film forming of a material on substrate 10. It includes a body 120 and a cover 150. A feeding wire (not shown) can be provided through the opening 154 in the cover 150 into the melting area of the first chamber 130.

Between the first chamber and the second chamber a transport region is provided. The first chamber 130 provides a melting area for melting the material and the second chamber 140 provides an evaporation area for evaporating the material provided from the melting area via the transport region.

The material to be deposited is melted and evaporated by heating the evaporation crucible 300. Heating can be conducted by providing a power source (not shown) connected to the first and second electrical connections (not shown). According to different embodiments, different temperatures across the body and, optionally, across the cover can be provided by varying the cross-sectional areas carrying a current and/or by varying the electrical resistivity of the crucible material in different areas. For example, the temperature in the melting area can be about 1000°C to 1200°C, the temperature in the transport region can be 1260°C to 1500°C, and the temperature in the evaporation area can be in the range of 1300°C to 1600°C, e.g., about 1560°C.

Generally, according to embodiments described herein, the materials of the crucible should be conductive, temperature resistant to the temperatures used for melting and evaporating the materials and should be resistant with regard to the liquid materials or the material vapor, respectively. For example, liquid aluminum is highly reactive and can provide significant damage to crucibles for melting aluminum. According to thereto, typically, materials selected from the group consisting of graphite or TiB₂, wherein AlN and/or BN can be added.

Fig 10 shows a cover 850. The cover 850 forms an enclosure with the bottom and the walls of the second chamber 140 and an enclosure with the bottom and the wall of the first chamber 130. The distributor orifice and the feed wire opening 154 are provided within the cover 850. According to different embodiments already explained with respect to Figs. 1a and 1b, the cover 150 can be made of the non-conductive material or a conductive material. Further embodiments of the evaporation crucible shown in Fig. 10 can be realized by the dimension of the first chamber, the second chamber and the transport region, which are described above. Yet further embodiments may be realized by the dimension of the distributor orifice.

Fig. 11 shows a portion of an evaporation unit. As an exemplary embodiment, a method of forming a thin film can be carried out by using an apparatus which is entirely placed in a vacuum atmosphere of 10⁻² -10⁻⁶ mbar. Thereby, the thin film can be vapor deposited on a substrate or a carrier foil without contamination of particles from ambient atmosphere.

Therein, three vertically aligned evaporation crucibles 300 are provided in front of a substrate 10. Between each of the crucibles and the substrate a respective aperture unit 510, as described with respect to Figs. 5 and 6, is provided. In light of the covers provided on the evaporation crucibles, the evaporation crucibles can be vertically arranged. Thus, a vertical nozzle pipe for redirecting material vapor at the plurality of positions for vertical evaporation can be omitted.

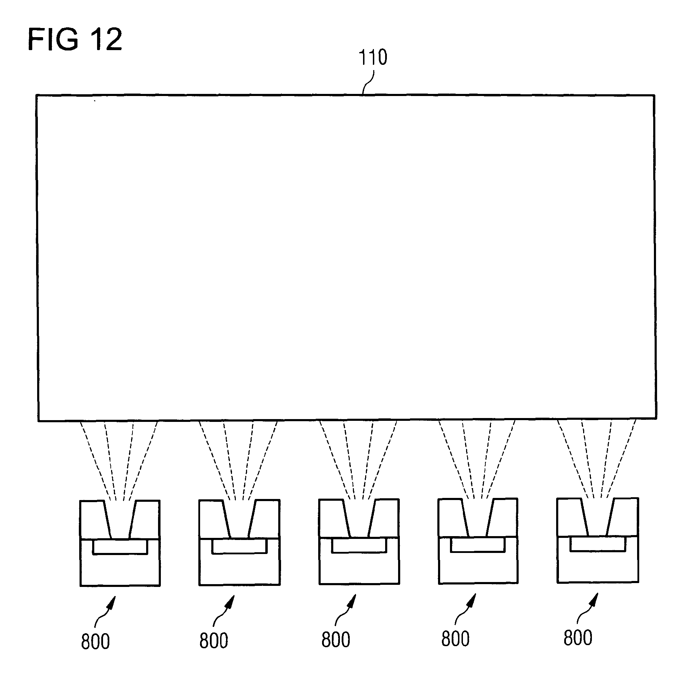

Fig. 12 shows an arrangement for horizontal evaporation of a substrate provided on a substrate carrying cylinder 110. The substrate carrying cylinder 110 moves a substrate across the position of the evaporation crucibles 800, which are described with respect to Fig. 8. The vertical directional evaporation axes of the evaporation crucibles 800 are provided next to each other, such that the substantially homogeneous coating of the substrate can be provided. According to one embodiment, each evaporation crucible is loaded with separate material wire. According to another embodiment, the substrate, which is carried by the substrate carrying cylinder 110, can be a foil. The direction of the movement of the foil and the orientation of the evaporation crucibles can be such that the foil is moved along the longitudinal direction of the substrate crucibles.

While the foregoing is directed to embodiments of the invention, other and further embodiments of the invention may be devised without departing from the basic scope thereof, and the scope thereof is determined by the claims that follow.

## Claims

1. Evaporation crucible (100; 200; 300; 400; 700; 800) comprising:
an electrically conductive body (120; 420) and a cover (150; 450; 750; 850);
the body having a first electrical connection (162) and a second electrical connection (164) for applying a heating current through the body, the body comprises:
a first chamber (130) providing a material feeding area and a melting area, the first chamber comprising a first chamber bottom and a first chamber wall;
a second chamber (140) providing an evaporation area, the second chamber comprising a second chamber bottom and a second chamber wall; and
a transport region (145) connecting the first chamber and the second chamber adapted for a flow of a material to be evaporated;
wherein the cover forms an evaporation enclosure with the second chamber;
wherein the body has a shape to provide a temperature gradient from the first chamber to the second chamber by increasing the current density in the second chamber; and
wherein the evaporation enclosure has a distributor orifice (179; 770) providing a vapor outlet.

2. Evaporation crucible according to any of the preceding claims, wherein the distributor orifice (179; 770) is provided at a boundary region between the cover and the second chamber wall of the second chamber (140).

3. Evaporation crucible according to any of the preceding claims, wherein the distributor orifice (179; 770) is provided in the cover (150; 750; 850).

4. Evaporation crucible according to any of the preceding claims, further comprising:
a cover portion forming a melting enclosure with the first chamber (130).

5. Evaporation crucible according to claim 4, wherein the cover portion is a portion of the cover.

6. Evaporation crucible according to any of claims 4 to 5, wherein the cover portion has a feeding opening (154).

7. Evaporation crucible according to claim 6, wherein the feeding opening is a feeding opening for feeding a material feed wire (102).

8. Evaporation crucible according to any of the preceding claims, wherein the body shape providing the temperature gradient has a higher resistance in the second chamber (140) than in the first chamber (130).

9. Evaporation crucible according to claim 8, wherein the higher resistance in the second chamber (140) is provided by a difference in material thickness of the chamber bottom of the first and the second chamber.

10. Evaporation crucible according to any of claims 8 to 9, wherein the higher resistance in the second chamber is provided by a difference in material thickness of the chamber walls of the first and the second chamber.

11. Evaporation crucible according to any of claims 8 to 10, wherein the higher resistance in the second chamber (140) is provided by a difference in electrical resistivity of materials of the first and the second chamber.

12. Evaporation crucible according to any of the preceding claims, wherein the transport region (145) is channel-like.

13. Evaporation crucible according to any of the preceding claims, wherein the first chamber bottom of the first chamber (130) and the second chamber bottom of the second chamber (140) are at different heights.

14. Evaporation crucible according to any of the preceding claims, wherein the body (120; 420) includes at least one material selected from the group consisting of: a metallic boride, a metallic nitride, a metallic carbide, a non-metallic boride, a non-metallic nitride, a non-metallic carbide, nitrides, borides, graphite, TiB2, BN, B₄C, SiC, and combinations thereof.

15. Evaporation crucible according to any of the preceding claims, wherein the distributor orifice (179; 770) has an evaporation axis (172) and the evaporation axis is substantially horizontal.

16. Evaporation crucible according to any of the preceding claims, wherein the distributor orifice has an evaporation axis and the evaporation axis is directed upwardly by an angle between the evaporation axis and a horizontal plane of 10° to 60°.

17. Evaporation crucible according to any of the preceding claims, wherein the distributor orifice (179; 770) has an evaporation axis (172) and the distributor orifice has a length along the evaporator axis of 2 mm to 15 mm.

18. Evaporation crucible according to any of the preceding claims, wherein the distributor orifice is funnel-shaped with the larger funnel diameter being located away from the evaporation enclosure.

19. Evaporation crucible according to any of the preceding claims, wherein the diameter of the distributor orifice is at least 4 mm.

20. Evaporation crucible according to any of the preceding claims, further comprising:
an aperture (512; 712) for controlling the evaporation characteristics of the evaporation crucible.

21. Evaporation crucible according to any of the preceding claims, wherein the aperture has a shape adapted for substantially compensating for a cos2ⁿ evaporation characteristics of the distributor orifice, wherein n is an integer.

22. Evaporation crucible according to any of the preceding claims, wherein the distributor orifice (179; 770) has an evaporation axis (172) and the aperture has a shape adapted for substantially compensating for a direction of the evaporation axis with regard to a substrate plane.

23. Evaporation crucible comprising:
a heatable body (120; 420) and a cover (150; 450; 750; 850);
the body comprises:
a first chamber (130) providing a material feeding area and a melting area, the first chamber comprising a first chamber bottom and a first chamber wall;
a second chamber (140) providing an evaporation area, the second chamber comprising a second chamber bottom and a second chamber wall; and
a transport region (145) connecting the first chamber and the second chamber adapted for a flow of a material to be evaporated; wherein the cover forms an evaporation enclosure with the second chamber;
wherein the body is heatable to provide an increasing temperature gradient from the first chamber to the second chamber; and
wherein the evaporation enclosure has a distributor orifice (179; 770) providing a vapor outlet.

24. Evaporation apparatus, comprising:
at least one evaporation crucible according to claim 23;
a heating unit adapted for heating the melting area and the evaporation area to different temperatures.

25. Evaporation apparatus according to claim 24, wherein the heating unit is an irradiation heating unit or an inductive heating unit.

26. Evaporation apparatus, comprising:
at least one evaporation crucible (100; 200; 300; 400; 700; 800) according to any of claims 1 to 23.

27. Evaporation apparatus according to claim 26, comprising:
at least two evaporation crucibles according to any claims 1 to 23.

28. Evaporation apparatus according to claim 27, wherein the at least two evaporation crucibles are vertically aligned.
